(19) Europäisches Patentamt
European Patent Office
Office européen des brevets

(11) **EP 4 296 780 A1**

(12) **EUROPEAN PATENT APPLICATION**

(43) Date of publication:
**27.12.2023 Bulletin 2023/52**

(21) Application number: **22180883.5**

(22) Date of filing: **24.06.2022**

(51) International Patent Classification (IPC):
**G03F 7/20** $^{(2006.01)}$    **G06T 5/00** $^{(2006.01)}$

(52) Cooperative Patent Classification (CPC):
**G03F 7/7065; G06T 5/00**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **COENE, Willem, Marie, Julia, Marcel**
**5500 AH veldhoven (NL)**

• **VAN KRAAIJ, Markus, Gerardus, Martinus, Maria**
**5500 AH Veldhoven (NL)**
• **KONIJNENBERG, Alexander, Prasetya**
**5500 AH Veldhoven (NL)**
• **DEN BOEF, Arie, Jeffrey**
**5500 AH Veldhoven (NL)**

(74) Representative: **ASML Netherlands B.V.**
**Corporate Intellectual Property**
**P.O. Box 324**
**5500 AH Veldhoven (NL)**

(54) **IMAGING METHOD AND METROLOGY DEVICE**

(57)    Disclosed is an imaging method comprising obtaining a set of primary deconvolution kernels or a set of impulse responses relating to an optical system used to capture said image; obtaining said image signal, said image signal being subject to one or more imaging effects including at least one or more non-isoplanatic imaging effects;
performing a low-rank approximation on said set of primary deconvolution kernels or impulse responses to determine respectively a set of deconvolution modes or a set of impulse response modes, each deconvolution mode comprising a modal secondary deconvolution kernel and a modal weight function and each impulse response mode comprising a modal impulse response and a modal inverse weight function; obtaining at least approximated imaging effect-free object information related to said object by applying said modal secondary deconvolution kernels and modal weight functions or said modal impulse responses and modal inverse weight functions to said image signal.

Fig. 7

EP 4 296 780 A1

**Description**

<u>FIELD</u>

The present invention relates to imaging generally, and to imaging in the context of a metrology method and device which may, for example, be used for determining a characteristic of structures on a substrate.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

Holographic metrology tools are known which enable phase information to be extracted from a holographic image. International patent application WO2019197117A1, incorporated herein by reference, discloses a method and metrology apparatus based on a dark field digital holographic microscope (df-DHM) to determine a characteristic, e.g., overlay, of a structure manufactured on a substrate.

Metrology tools may have lens systems which comprise aberrations and/or other imaging effects which should be corrected. This is particularly the case if the lens systems are simplified, e.g., to reduce their cost and/or complexity. Some of these aberrations and/or imaging effects can be isoplanatic, others can be non-isoplanatic. It would be desirable to computationally correct at least some of these aberrations and/or imaging effects, even where the aberrations and/or imaging effects are non-isoplanatic.

<u>SUMMARY</u>

Embodiments of the invention are disclosed in the claims and in the detailed description.

In a first aspect of the invention, there is provided an imaging method comprising: obtaining a set of primary deconvolution kernels or a set of impulse responses relating to an optical system used to capture said image, where each primary deconvolution kernel of said set of primary deconvolution kernels relates to a respective object point of an object, and each impulse response of said set of impulse responses relates to a respective image point of an image signal; obtaining said image signal relating to said object, said image signal being subject to one or more imaging effects, said imaging effects including at least one or more non-isoplanatic imaging effects; performing a low-rank approximation on said set of primary deconvolution kernels or impulse responses to determine respectively a set of deconvolution modes or a set of impulse response modes, each deconvolution mode respectively comprising a modal secondary deconvolution kernel and a modal weight function and each impulse response mode comprising a modal impulse response and a modal inverse weight function; and obtaining at least approximated imaging effect-free object information related to said object by applying said modal secondary deconvolution kernels and modal weight functions or said modal impulse responses and modal inverse weight functions to said image signal.

In a further aspect of the invention, there is provided a computer program comprising program instructions operable to perform the method of the first aspect when run on a suitable apparatus, and associated processing apparatus and metrology device.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 depicts a matrix equation relating an image and imaged object;
- Figure 6 is a flow diagram illustrating a theoretical image correction strategy;
- Figure 7 is a flow diagram illustrating an initial preparatory step of a method according to an embodiment;
- Figure 8(a) illustrates a singular value decomposition and Figure 8(b) a truncation thereof;
- Figure 9 is a flowchart describing a method according to an embodiment of the invention;
- Figure 10 depicts a block diagram of a computer system for controlling a system and/or method as disclosed herein; and
- Figures 11(a), 11(b), 11(c), 11(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

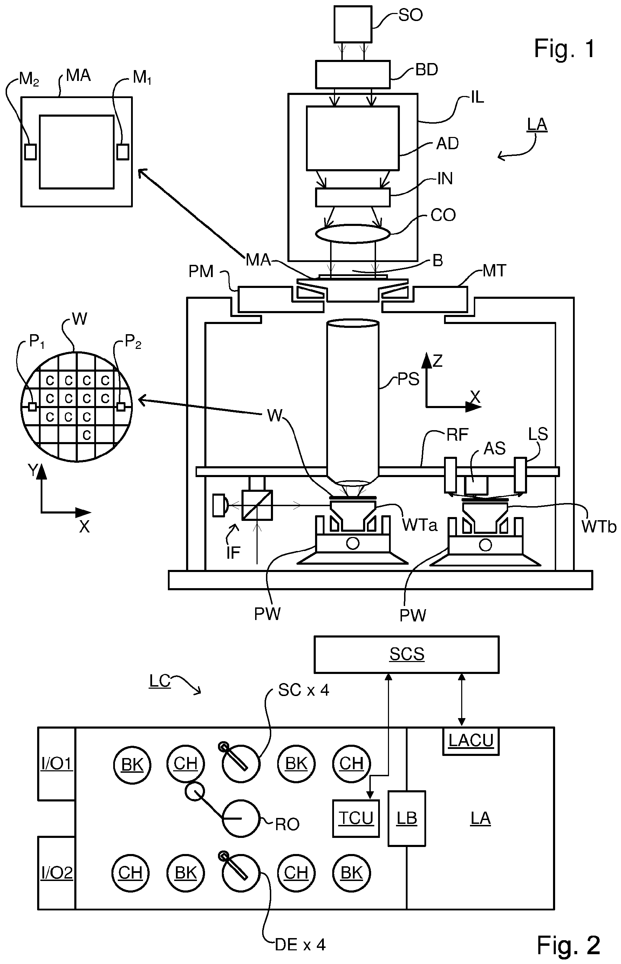

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

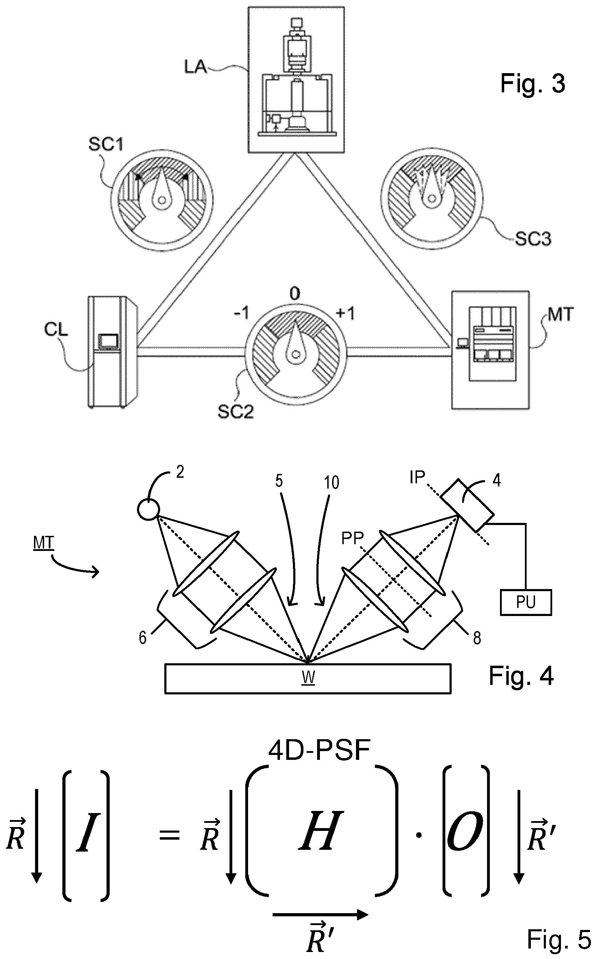

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

A metrology apparatus, such as a scatterometer MT, is depicted in Figure 4. It comprises a radiation source 2 (e.g., a broadband (white light) radiation source) which projects radiation 5 onto a substrate W via projection optical system 6. The reflected or scattered radiation 8 is collected by an objective lens system 8 and passed to a detector 4. The scattered radiation 8 as detected by detector 4 can then be processed by processing unit PU. Also shown is a pupil plane PP and image plane IP of the objective lens system 8. The terms "pupil plane" and "field plane" within this specification may refer to respectively these planes or any planes conjugate thereto. Such a scatterometer may be configured as a normal-incidence scatterometer or (as shown) an oblique-incidence scatterometer. In some embodiments, the projection optical system 6 and objective lens system 8 are combined; i.e., the same objective lens system is used to both illuminate the substrate and collect the scattered radiation therefrom.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Metrology tools typically require low aberrations (for good machine-to-machine matching for example) and a large wavelength range (to support a large application range for example). Machine-to-machine matching depends (at least partly) on aberration variation of the (microscope) objective lenses being sufficiently small, a requirement that is challenging and not always met. This also implies that it is essentially not possible to enlarge the wavelength range without worsening the optical aberrations. Furthermore, the cost of goods, the volume and/or the mass of a tool is substantial, limiting the possibility of increasing the wafer sampling density (more points per wafer, more wafers per lot) by means of parallelization by providing multiple sensors to measure the same wafer simultaneously. Aberrations in the context of this disclosure may refer to imperfections in the lenses that cause a wavefront error in the transmitted optical field.

To address at least some of these issues, a metrology apparatus which employs a computational imaging/phase retrieval approach has been described in US patent publication US2019/0107781, which is incorporated herein by reference. Such a metrology device may use relatively simple sensor optics with unexceptional or even relatively mediocre aberration performance. As such, the sensor optics may be allowed to have aberrations, and therefore produce a relatively aberrated image. Of course, simply allowing larger aberrations within the sensor optics will have an unacceptable impact on the image quality unless something is done to compensate for the effect of these optical aberrations. Therefore, computational imaging techniques are used to compensate for the negative effect of relaxation on aberration performance within the sensor optics.

A known type of metrology which may be used *inter alia* in lithography control and monitoring applications is digital holographic microscopy, in particular dark field digital holographic microscopy. Digital holographic microscopy is an imaging technology that combines holography with microscopy. Different from other microscopy methods that record projected images of an object, digital holographic microscopy records holograms formed by interference between object radiation obtained by irradiation of a three-dimensional (3D) object with reference radiation that is coherent with the object radiation. Images may be captured using, for example a charge coupled device (CCD) or a complementary metal oxide semiconductor (CMOS). Since the object radiation is radiation scattered from the object, wave-front of the object radiation is therefore modulated or shaped by the object. Said scattered radiation may comprise reflected radiation, diffracted radiation, or transmitted radiation. Therefore, the wavefront of the object radiation carries information of the irradiated object, e.g., 3D shape information. Based on the captured images of holograms, images of the object can be numerically reconstructed by using a computer reconstruction algorithm. An important advantage of hologram based metrology over intensity based metrology, is that hologram based metrology allows both intensity and phase information of an object to be obtained, without the need for the computationally intensive phase retrieval techniques described in the aforementioned US2019/0107781. With additional phase information, sensor aberrations may be corrected therefore also enabling a simpler sensor optical setup to be used.

The international patent application WO2019197117A1, incorporated herein by reference, discloses a method and metrology apparatus based on a dark field digital holographic microscope (df-DHM) to determine a characteristic, e.g., overlay, of a structure manufactured on a substrate. The df-DHM in described therein comprises a reference optical unit which is used to provide two reference radiation beams (the reference radiation). The two reference radiation beams may be respectively paired with two corresponding portions of object radiation (e.g., scattered radiation beams from a target), such as a +1 diffraction order and a -1 diffraction order. The two scattered-reference beam pairs are used sequentially to form two interference patterns (i.e., one corresponding to the +1 diffraction order and the other corresponding to the -1 diffraction order). The first and second interference patterns are used to determine the characteristic of the structure. Holographic microscopes such as the df-DHM may be subject to 4D aberrations and other imaging effects, and as such, the methods disclosed herein may be used to correct for imaging effects in holographic microscopes or other metrology tools. Imaging effects may comprise any effects that can be described by a linear operator, such as aberrations. Other imaging effects in DHM metrology may comprise imaging artifacts, which can be caused by the finite bandwidth of the light with which DHM is performed.

In DHM, with monochromatic radiation, the complex-valued image field *i(x, y)* is computed from an intensity measurement *I(x, y)* as follows. The image field *i(x, y)* is allowed to interfere with an off-axis reference wave $e^{i\alpha x}$ (for simplicity, it assumed that the reference wave is tilted in the x-direction, but this does not necessarily have to be the case. Moreover, the reference wave may contain imperfections, i.e., deviations from an ideal plane wave). The measured intensity is then given by:

$$I(x,y) = \left|i(x,y) + e^{i\alpha x}\right|^2 = |i(x,y)|^2 + 1 + i(x,y)e^{-i\alpha x} + i(x,y)^* e^{i\alpha x}$$

To reconstruct *i(x, y)*, *I(x, y)* may be Fourier transformed and the sideband corresponding to $i(x, y)e^{-i\alpha x}$ isolated using some window function $W(\xi, \eta)$. Inverse Fourier transforming this result, and multiplying with $e^{i\alpha x}$ yields *i(x, y)*, as desired. This may be described by:

$$i(x,y) = \mathcal{F}^{-1}\{\mathcal{F}\{I(x,y)\}(\xi,\eta) \cdot W(\xi,\eta)\}(x,y)e^{i\alpha x}.$$

Note that this operation, as applied to *I(x, y)*, is linear.

If the measurement radiation has a finite bandwidth, the measured intensity *I(x, y)* is the linear combination of monochromatic intensities $I_\lambda(x, y)$ for different wavelengths $\lambda$, weighted by the spectrum $S(\lambda)$:

$$I(x,y) = \int S(\lambda)I_\lambda(x,y)d\lambda.$$

If each monochromatic intensity $I_\lambda(x, y)$ yields a reconstruction $i_\lambda(x, y)$, then the linear combination of $I_\lambda(x, y)$ yields a linear combination of reconstructions $i_\lambda(x, y)$ (due to the linearity of the reconstruction operation):

$$\tilde{i}(x,y) = \int S(\lambda)i_\lambda(x,y)d\lambda$$

Note that, while the intensities $I_\lambda(x, y)$ add incoherently, the reconstructions $i_\lambda(x, y)$ add coherently. This means that any phase differences between $i_\lambda(x, y)$ result in visible amplitude variations when the $i_\lambda(x, y)$ are added together. Phase differences between the $i_\lambda(x, y)$ are caused by the fact that for different wavelengths $\lambda$, the field undergoes different phase shifts when it goes through the imaging lens. It has been observed experimentally that this can cause significant amplitude modulations in the pupil field, which are highly non-isoplanatic. These non-isoplanatic imaging effects can also be corrected (in addition to aberration effects) using the methods described herein.

The remainder of the description will be described largely in the context of aberration correction; however it should be appreciated that any mention of aberration correction and non-isoplanatic aberrations includes (unless not appropriate) any imaging effect correction and non-isoplanatic imaging effects.

Simplifying the illumination and detection sensor optics of some of the metrology devices described above, and/or making the optics more compact, elevates the sensor's Petzval sum and may lead to large by-design, and possibly also as-manufactured, aberration levels. Such aberration may comprise, for example 4D aberration, where 4D aberration refers to the fact that each object point (described by a 2D coordinate vector) has its own 2D aberration function (and therefore its own PSF). This is the most general form of non-isoplanatic aberrations.

For a specific subset of 4D aberrations, it is possible to correct for aberrations by simple deconvolution operations. This specific subset of 4D aberrations comprises one or both of the following categories of aberrations: isoplanatic field aberrations (dependent on pupil coordinate) and/or isoplanatic pupil aberrations (dependent on field coordinate). For such case, and assuming coherent imaging regimes, such as may be implemented using a df-DHM or other coherent holographic microscope, the aberration correction may be performed by means of simple deconvolution (or other correction) based on two 2D-Fast Fourier Transforms (FFTs). Briefly, such an approach may comprise the following steps:

- Perform forward FFT of hologram and select sideband.
- Deconvolution in pupil space representation to correct isoplanatic pupil aberrations.
- Perform backward FFT to field representation.
- Deconvolution in field representation to correct isoplanatic field aberrations.

This method works only for a certain restricted subset of 4D aberrations, but not all arbitrary 4D aberrations.

In an incoherent regime (e.g., using a tool such as illustrated in Figure 4 and computational imaging), the only aberration corrections possible using known methods such as described above are field plane corrections (e.g., using deconvolution in the field plane), as the pupil plane (or Fourier plane, or simply "pupil") is not accessible (the latter would require the knowledge of the complex field), such that it is possible to transform between field space and pupil space by a forward or backward 2D Fourier transform.

However, these approaches can only be used for isoplanatic aberration correction due to physics and/or time constraint limitations. Isoplanatic aberrations in this context refers to aberrations which are dependent only on pupil plane coordinates, and/or dependent only on field plane coordinates. It may be appreciated that the former of these definitions, i.e., aberrations which are dependent only on pupil plane coordinates, is the more common definition of isoplanatic and it is well known that deconvolutions can be applied to correct for such aberrations. However, the same approach also works for aberrations dependent only on field coordinates. By extension, in the context of this disclosure, non-isoplanatic aberrations refers to aberrations which are dependent on both pupil plane coordinates and field plane coordinates (each object point has different point spread function (PSF) in field plane, also referred to as the image plane).

Because of this, present aberration correction methods have only a very limited aberration correction potential; the concepts disclosed herein, by contrast, have a greater aberration correction potential as they include correction for non-isoplanatic aberrations. In particular, a method for direct aberration correction (DAC) of aberrations generally, including non-isoplanatic aberrations, is proposed.

Generally, the non-isoplanatic coherent imaging case (as applied in digital holographic microscopy, DHM) in field (real) space $(\vec{R})$, the coherent image field subject to non-isoplanatic aberration $\phi_{ima,coh}^{non-iso}\left(\vec{R}\right)$ may be described by:

$$\phi_{ima,coh}^{non-iso}\left(\vec{R}\right) = \int h\left(\vec{R};\vec{R'}\right) \phi_{obj}\left(\vec{R'}\right) d\vec{R'}$$

where $h(\vec{R};\vec{R'})$ is the 4D PSF (non-isoplanatic) describing position variant aberration (and/or other imaging effect(s)) such as position variant local blur and position variant local image shift and $\phi_{obj}(\vec{R'})$ describes the object field or sample field (it is actually the modulation of a plane wave; and it is complex-valued).

In the non-isoplanatic incoherent imaging case (as applied in a metrology tool such as illustrated in Figure 4) in field (real) space $(\vec{R})$, the incoherent image field subject to non-isoplanatic aberration $\phi_{ima,inc}^{non-iso}\left(\vec{R}\right)$ may be described by:

$$I_{ima,inc}^{non-iso}(\vec{R}) = \int \left| h\left(\vec{R};\vec{R'}\right) \right|^2 \left| \phi_{obj}\left(\vec{R'}\right) \right|^2 d\vec{R'}$$

The description below will be described mainly in terms of the incoherent case; however, the concepts are equally applicable to coherent and incoherent imaging.

The image power (or wave in the coherent case) may be captured as a 2D array of values ($R_x \times R_y$, each corresponding to a pixel $N_x \times N_y$ of the captured image; this may be represented as a 1D vector $\vec{R}$ having $N$ rows, where $N = N_x \times N_y$.

In such a case, the measurement signal or image power $I_{ima}(\vec{R})$ may be decomposed as a linear system:

$$I_{ima}(\vec{R}) = \int H\left(\vec{R};\vec{R'}\right) O\left(\vec{R'}\right) d\vec{R'} \qquad (1)$$

wherein H($\vec{R}$; $\vec{R'}$) is the 4D (position variant) PSF power and $O(\vec{R'})$ is the object power. Note that in the coherent case, the equivalent relation may be expressed in terms of waves or fields, instead of powers. Figure 5 shows this equation represented in terms of a matrix equation of said linear system, with an indication of the size of the matrices for each power. The image and object matrices are each $N \times 1$ matrices while H($\vec{R}$; $\vec{R'}$) is a 4D PSF, comprising an $N \times N$ matrix. The imaged object can be a complex valued field in the spatially coherent case, or a real-valued image intensity (or power) in the spatially incoherent case). In both of these cases, the imaging can be described as a linear system with transfer characteristics denoted by *H.*

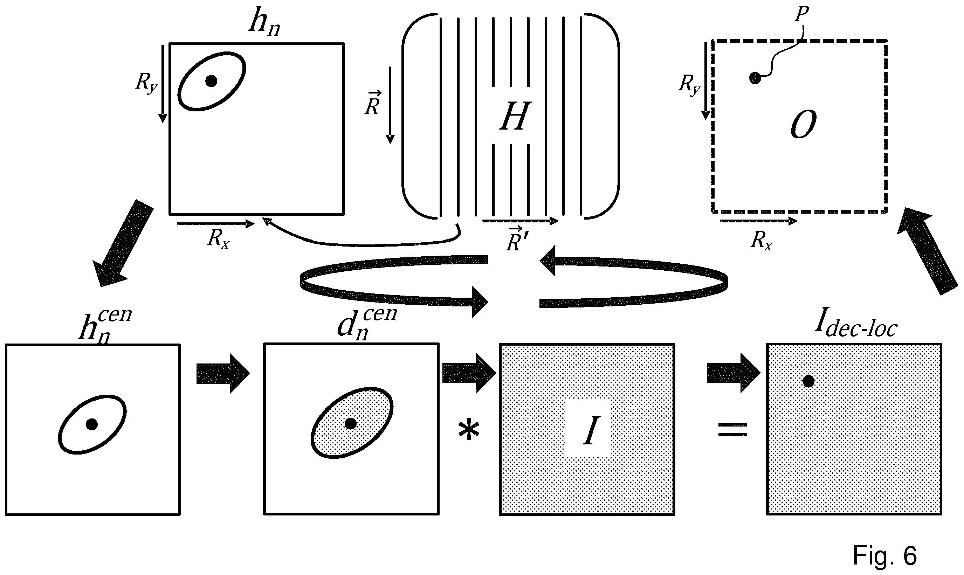

Figure 6 is a flow diagram for a hypothetical method of direct aberration correction. At every point in the object (which can be related to a respective point of the related image in the image plane), a corresponding local 2D-PSF can be defined which generates the contributions to the image originating from that single object point. Such a method should be done on a per-pixel basis because, in case of non-isoplanatism, the local 2D-PSF varies from object point to object point.

Referring to Figure 6, a single object point $P$ in the object $O$ is shown. A local 2D-PSF $h_n$ corresponding to this point $P$ can be determined from the 4D-PSF $H$. This can be aligned or centered $h_n^{cen}$ and used to construct a local 2D-deconvolution kernel $d_n^{cen}$. The latter local 2D-deconvolution kernel $d_n^{cen}$ can be applied on the complete, as captured, image wave (coherent) or image intensity (incoherent) $I$. Subsequently, only one single point $P$ of this deconvolved wave or intensity $I_{dec\text{-}loc}$ is used as corrected information, this being the considered point $P$ in the object. This procedure is repeated for all object points or pixels $n$. Because of the need to do this for each of (for example) 128x128 or 256x256 pixels, such a point-per-point deconvolution is computationally very expensive and therefore an impractical solution for direct aberration correction in a production setting.

It may be appreciated that the local 2D-PSF $h_n$ can also be measured; if so then imaging effects other than aberration can also be taken into account.

To provide a practical solution for direct aberration correction, it is proposed to use a low-rank approximation method, such as a singular value decomposition (SVD)-based approach. The low-rank approximation or SVD is applied on a 4D set of deconvolution kernels, each of which corresponds to a specific point in the object (as described above in the context of the point-per-point deconvolution approach) and where the deconvolution kernels are arranged in order to arrive at an efficient compaction of the SVD. Such an approach replaces a per-point deconvolution for full field-of-view, as has been described, with a limited series of vector-vector products and convolutions, the latter having a low computational cost as they can be implemented by the use of FFTs which converts the convolutions into vector-vector products in the considered Fourier space.

The proposed approach shares some similarities with the approach described in L. Denis, E. Thiebaut, F. Soulez, J.-M. Becker, R. Mourya, Fast Approximations of Shift Variant Blur, Int. J. Comput. Vis. Vol. 115, 2015, pp. 253-278, which is incorporated herein by reference. However, the approach described in that paper is not a direct aberration correction, but rather an iterative correction which comprises iteratively inverting for the object based on the forward model (describing the measured signal in terms of the object) using a gradient based inversion on a mean-squared error functional (MSE) between the measured image signal (power of wave) and the modeled image signal (power or wave); the modeled image signal is generated via Equation (1) for the current version of the object function and with knowledge of the linear imaging model represented by H. By contrast, disclosed herein is a non-iterative, direct aberration correction comprising a limited number of single step (non-iterative) "deconvolutions"; more strictly a limited number of single step convolutions with a respective deconvolution kernel applied on a respective weighted version of the image function (intensity or wave). This is much less computationally complex and therefore much faster to perform.

The low-rank approximation or SVD generates a limited set of deconvolution-modes, where each mode comprises a modal 2D deconvolution kernel, and a modal weight function. For each mode, a modal weight function may be combined or multiplied with the as-measured image signal (e.g., image wave in a coherent regime or image intensity in an incoherent regime). Subsequent to this, the modal deconvolution-kernel may be applied to the resultant product; e.g., via fast Fourier transforms (FFTs). The contribution of all modes of the limited set of deconvolution-modes may then be summed to yield the retrieved object (e.g., object wave or object power depending on the imaging regime).

Technically, the SVD may be performed on an unaligned deconvolution kernel matrix determined directly from the 4D-PSF $H(\vec{R}; \vec{R'})$, and doing this is within the scope of the disclosure. However the 4D-PSF $H(\vec{R}; \vec{R'})$ contains spatially non-aligned PSFs, which are dependent on the position $\vec{R'}$ of the "source" point in the object. Because of this, a set of deconvolution kernels e.g., in the form of an aligned deconvolution kernel matrix $K$, may be determined from matrix $H(\vec{R}; \vec{R'})$ so as to improve efficiency of the SVD, as the SVD should not waste its compaction power for known lateral shifts of the PSFs as present in $H$. The aligned deconvolution kernel matrix $K$ may comprise a 2D deconvolution kernel per object point or pixel (point source), all aligned on a common point (e.g., centered).

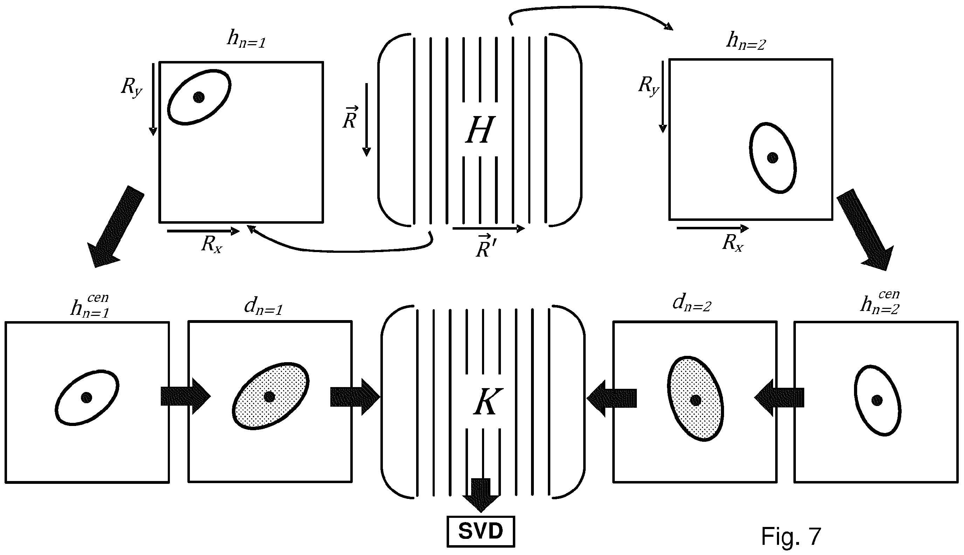

Figure 7 is a flow diagram describing a procedure for building such an aligned deconvolution kernel matrix $K$ for the proposed SVD method, such that the SVD can then generate the deconvolution modes. The Figure represents the method for two object points or pixels, here nominally designated n=1 and n=2, this step is repeated for all object points or pixels. The 4D-PSF $H(\vec{R}; \vec{R'})$ data may be determined, for example, from the aberrations of the optical system; these aberrations may be known (provided by the supplier e.g., following qualification), measured (e.g., via specific calibrations) and/or simulated. The 4D-PSF $H(\vec{R}; \vec{R'})$ may be measured and if so, the measured 4D-PSF $H(\vec{R}; \vec{R'})$ may also already include the effects from aberrations and the other non-isoplanatic imaging effects. For each object point $n$, a 2D-PSF $h_n$ is determined. This 2D-PSF $h_n$ is then aligned to a common point with all the other 2D-PSF $h_n$, e.g., in this case they are all centered $h_n^{cen}$. Based on the centered 2D-PSF $h_n^{cen}$, a (centered/aligned) 2D primary deconvolution kernel $d_n$ is determined. The deconvolution kernels for each objection point $n$ can then be represented within an (aligned) deconvolution kernel matrix $K$, having the same dimensions as matrix $H$. The SVD (or other low-rank approximation method) can then be performed on deconvolution kernel matrix $K$.

The primary deconvolution kernel may be derived from the centered 2D-PSF $h_n^{cen}$ as follows. Firstly, the Fourier transform of the 2D-PSF $h_n^{cen}$ from real space to Fourier space is computed, where the resulting function is referred to as the 2D transfer function. Then, an inverse (e.g., a Wiener filter type inverse) of this 2D transfer function is computed; this may essentially be determined as the reciprocal of the transfer function, e.g., with additional measures in order to avoid noise amplification upon division by small numbers close to zero. In the case of ideal coherent imaging, the amplitude of the transfer function primarily comprises the binary aperture function; comprised within the aperture is a phase factor having phase expressed typically by the well-known (space varying) Zernike expansion or the non-isoplanatic Hopkins expansion (see J. Sasian's book, Introduction to Aberrations in Optical Imaging Systems, Table 5.1, incorporated herein by reference). In determining the primary deconvolution kernel for ideal coherent imaging, in Fourier space, the phase simply changes sign within the aperture. As a final step, a backwards Fourier transform from Fourier space to real space is performed, yielding the 2D primary deconvolution kernel $d_n$. In the case of incoherent imaging, the 2D transfer function in Fourier space has a considerable amplitude component which should be inverted in the above procedure, e.g., using a noise-robust Wiener type of approach.

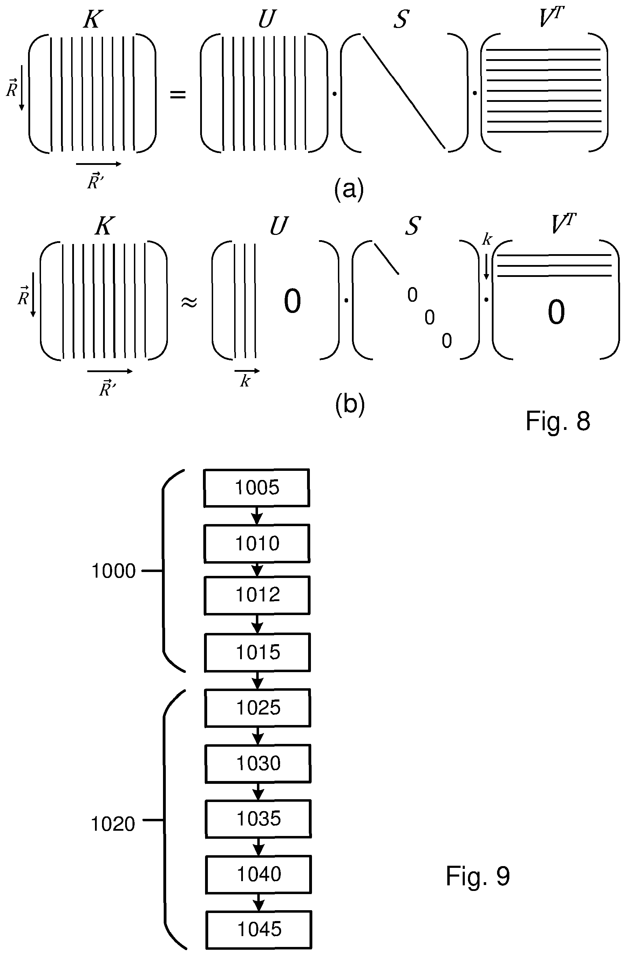

Figure 8 conceptually illustrates an SVD step as may be performed on the deconvolution kernel matrix $K$. As is known, SVD decomposes a matrix, in this case deconvolution kernel matrix $K$, into three matrices $U$, $S$ (or $\Sigma$) and $V^T$ (Figure 8(a)). Following this, the deconvolution kernel matrix $K$ may be approximated by a truncated deconvolution kernel matrix $\tilde{K}$ comprising a limited number of modes $k_{max}$, such that truncated singular value matrix $s_k$ comprises only the $k_{max}$ largest singular values, with the other singular values being replaced by zero; i.e.:

$$K \approx \tilde{K} = \sum_{k=1}^{k_{max}} u_k(\vec{R}) \, s_k \, v_k^T(\vec{R'})$$

where $u_k$, $s_k$ and $v_k^T$ are the vectors linked to the limited set of the largest singular values of the truncated approximations of $U$, $S$ and $V^T$ respectively. The number of modes $k_{max}$ is user definable and may be chosen based on a desired or required accuracy (the higher the number of modes $k$, the more accurate the approximation). As such, the accuracy of the aberration correction may be tuned via parameter $k_{max}$, with increased accuracy to be balanced against the cost of additional convolutions/FFTs (and therefore time). For example, $k_{max}$ may reside in a range having a lower bound between 1 and 20 and an upper bound between 50 and 1000. For example, number of modes $k_{max}$ may be any value between 1 and 1000, between 1 and 500, between 1 and 200, between 1 and 100, between 5 and 1000, between 5 and 500, between 5 and 200, between 5 and 100, or between 10 and 100. Furthermore, it may be appreciated that the level of non-isoplanatism may also determine the practical value of $k_{max}$. For example, for pure isoplanatic imaging, number of modes $k_{max}$ can be set to 1, as all other singular values will be zero by definition.

Following this decomposition, the left-singular vectors $u_k(\vec{R})$ may be used to determine modal deconvolution kernels $d_k(\vec{R})$ for each mode $k$ (e.g., via a one-to-one mapping such that $u_k(\vec{R}) = d_k(\vec{R})$). The product $s_k\, v_k^T(\vec{R'})$ of the singular values $s_k$ and transposed right-singular vectors $v_k^T$ may be used to determine corresponding modal weights $w_k(\vec{R'})$ (e.g., again via a one-to-one mapping such that $s_k\, v_k^T(\vec{R'}) = w_k(\vec{R'})$). As such, the 4D deconvolution matrix $DECON(\vec{R}; \vec{R'})$ may be approximated by:

$$DECON\left(\vec{R}; \vec{R'}\right) \approx \sum_{k=1}^{k_{max}} d_k\left(\vec{R} - \vec{R'}\right) w_k\left(\vec{R'}\right)$$

where $d_k(\vec{R} - \vec{R'})$ describes the application of the deconvolution operation.

The object $O(\vec{R})$ can be described by:

$$O\left(\vec{R}\right) = \int DECON\left(\vec{R}; \vec{R'}\right) I\left(\vec{R'}\right) d\vec{R'}$$

Therefore, the object may be approximated as the sum over modes $k$ of spatially weighted versions of the measured signal or measured image power $I_{ima}(\vec{R})$ (measured signal image wave in the coherent regime) convolved with the deconvolution kernels $d_k(\vec{R})$:

$$O\left(\vec{R}\right) \approx \sum_{k=1}^{k_{max}} d_k\left(\vec{R}\right) * \left[w_k\left(\vec{R}\right) I_{ima}\left(\vec{R}\right)\right]$$

as such, the object may be approximated by $k_{max}$ isoplanatic convolutions on spatially weighted versions of the image.

The computational complexity of this SVD-on-Deconvolution-Kernels based DAC method essentially comprises $k_{max}$ FFTs, where $k_{max}$ is the number of singular values or modes retained in the SVD-decomposition. $k_{max}$ may typically range from 10 up to 100, depending on the amount of non-isoplanatism which is present in the images obtained from a particular objective lens. By contrast, a per-pixel correction (such as described in relation to Figure 6) would require N FFTs, where the number of pixels (N) within the Field-of-View (FoV), by way of a typical example, may be 128x128 or 256x256.

Such a method may be able to correct most or all aberrations (both isoplanatic and non-isoplanatic).

Figure 9 is a flow diagram of a method embodying the above teachings. At step 1005, a matrix $H$ comprising 4D-PSF (each PSF relating to a point in the object) is determined from the known/measured/simulated aberrations of the optical system. At step 1010, a deconvolution kernel matrix $K$ (comprising primary deconvolution kernels) is determined from the 4D-PSF matrix. Following this, at step 1012 a centering or alignment step is performed on each of the primary deconvolution kernels within the matrix to align the deconvolution kernels onto a common point. At step 1015, a low-rank approximation, such as an SVD approximation is performed on matrix $K$ to determine a limited set of deconvolution modes, each mode comprising a 2D deconvolution kernel and respective (2D) modal weight function. The number of deconvolution modes can be chosen arbitrarily, tuned to achieve a desired accuracy, or can be based on ignoring deconvolution modes with (quite) low model weight functions. Steps 1005 to 1015 may be performed offline, e.g., as calibrations in a calibration stage 1000.

In a correction stage 1020, for example, each measured image may have aberrations corrected by application of the set of 2D modal secondary deconvolution kernels and modal weight functions for each deconvolution mode and summing the intermediate results into the final aberration corrected object function (more specifically, its Fourier transform).. This correction stage may comprise the following steps. At step 1025, the measured image may be multiplied with each modal weight function to obtain spatially weighted versions of the image. At step 1030, the each modal spatially weighted version of the image may be transformed into the Fourier domain and, at step 1035, then convolved with the modal secondary deconvolution kernel for each respective deconvolution mode. At step 1040, the convolutions of step 1035 are summed and at step 1045, a reverse Fourier transformation is performed to obtain an aberration corrected description the object. Steps 1040 and 1045 may technically be reversed: a reverse Fourier transformation may be applied to each convolution of step 1035 and then summed. However, this would be computationally more expensive.

As an alternative to steps 1030 to 1045, i.e., performing Fourier transforms/FFT steps and elementwise multiplication, a convolution may sometimes be performed more efficiently by a simple matrix multiplication. This may be the case, for example, when local sparse deconvolution modes are used rather than a global SVD-based compression.

The object function O(R), once approximated using the methods described herein, may be used directly as the aberration corrected image; i.e., the object function and corresponding aberration corrected image function may be assumed to be identical.

More specifically, it may be appreciated that the object can be retrieved up to the diffraction limit as imposed by the numerical aperture of the lens used; there is no information available in the image from beyond the NA. As such, the object (function) may be understood to be the aberration-free diffraction-limited information (in terms of field for coherent imaging or intensity for incoherent imaging, for example) of the sample. In that sense, the object function can be retrieved by the aberration correction procedure, and the aberration corrected image ideally would be identical to that object function. In reality, there may be differences between the object function and the practical aberration corrected image due to noise and/or any error in the assumed aberrations of the lens used. Strictly speaking, the object function (wave or power/intensity) is the aberration-free diffraction-limited information of the sample, which may be assumed to be the same as the aberration corrected image function (wave or power/intensity).

Once the object function O(R) is determined, it can be digitally propagated through a coherence model in order to remove coherent cross-talk effects i.e., to convert from the coherent to incoherent domain.

This method of using PSF modes of the forward model to apply local deconvolutions is simple to apply and non-iterative, but obtains only an approximate solution. A variation on this method will now be described which provides a computational 4D aberration correction that is both exact and non-iterative (i.e., computationally efficient; the exact efficiency depends on the degree of non-isoplanatism). The trade-off is that this embodiment requires an additional computationally expensive pre-calculation for a given 4D aberration function. However, once that has been done, any image that has been aberrated by that function can be computationally corrected efficiently.

This method is based on the concept that the inverse computation can be sped up in the same way that the forward computation can be sped up. As has been described, the forward computation (i.e., the computation of a corrected image) can be described by the linear operator $H$ such that the image $I$ of an object $O$ is given by the matrix-vector product $I = HO$. This applies to fully coherent or incoherent images, assuming the complex field is measured in the coherent case, and the intensity in the incoherent case.

This embodiment essentially describes applying the basic method already described (e.g., applying an SVD or low-rank approximation) to pseudo-inverse 4D-PSF $H^{-1}(\vec{R}; \vec{R'})$, which is the pseudo-inverse of 4D-PSF $H$. More specifically, the SVD or low-rank approximation may be applied to centered inverse PSFs (i.e., an inverse or pseudo-inverse of the matrix $K$). Computing the pseudo-inverse 4D-PSF $H^{-1}(\vec{R}; \vec{R'})$ is computationally expensive, but this only has to be performed once, e.g., as part of a pre-calculation. The pseudo-inverse 4D-PSF $H^{-1}(\vec{R}; \vec{R'})$ may be determined in a brute-force pre-calculation, e.g., by applying SVD to the 4D-PSF $H$ and setting the non-zero singular values to their reciprocals.

Once pseudo-inverse 4D-PSF $H^{-1}(\vec{R}; \vec{R'})$ has been found, it can be used to compute 'inverse PSFs', i.e., the impulse responses of point sources in the image plane. These inverse PSFs can be shifted to a common central position to find an inverse equivalent of deconvolution kernel matrix $K$; which may be referred to as inverse deconvolution kernel matrix or (centered) impulse response matrix $\tilde{K}$. Applying SVD to this inverse deconvolution kernel matrix $\tilde{K}$, yields a computationally efficient implementation of $H^{-1}$, thereby enabling computationally efficient non-iterative 4D aberration correction.

As such, this embodiment may comprise applying pseudo-inverse 4D-PSF $H^{-1}(\vec{R}; \vec{R'})$ to each image point source, e.g., each point or pixel, $(x_{im}, y_{im})$ described by vector $\vec{R}$ to find their respective inverse PSFs $PSF^{-1}(\vec{R}; \vec{R'})$. Shifting all 'inverse PSFs' $PSF^{-1}(\vec{R}; \vec{R'})$ to a common position or common center (find the inverse equivalent of $K$), and applying SVD or other low-rank approximation to find inverse PSF modes or modal impulse response $PSF_k^{-1}\left(\vec{R'}\right)$ and respective modal inverse weight function $W_k^{-1}\left(\vec{R}\right)$. The application of the SVD on matrix $\tilde{K}$ to determine the inverse PSF modes $PSF_k^{-1}\left(\vec{R'}\right)$ and respective inverse modal weights $W_k^{-1}\left(\vec{R}\right)$ is analogous and essentially similar to the application of SVD on matrix $K$ to determine deconvolution kernels $d_k(\vec{R})$ and modal weights $w_k(\vec{R'})$. As

such, the left-singular vectors $u_k(\vec{R'})$ may be used to determine inverse PSF modes $PSF_k^{-1}\left(\vec{R'}\right)$ and the product

$s_k\,v_k^T\left(\vec{R}\right)$ of the singular values $s_k$ and transposed right-singular vectors $v_k^T$ may be used to determine corresponding inverse modal weights $W_k^{-1}\left(\vec{R}\right)$.

The method of this embodiment may require more modes to apply the non-isoplanatic aberration/imaging effect correction non-iteratively, compared to the number of modes of the method described by Figure 9 and described above; however, the number of modes typically required is still acceptable. In any case, the number of modes used in this embodiment may be described by any of the ranges disclosed in the previous embodiment.

Once performed, the method provides an efficient implementation of pseudo-inverse 4D-PSF $H^{-1}\left(\vec{R};\vec{R'}\right)$. The inversion is performed in the same way as described in the previous embodiment: the image field is multiplied with the inverse weights, and then convolved with the inverse PSF; the modes are then added together:

$$O\left(\vec{R}\right) = \sum_{k=1}^{k_{max}} PSF_k^{-1}\left(\vec{R'}\right)\,*\,\left[W_k^{-1}\left(\vec{R}\right)\,I_{ima}\left(\vec{R}\right)\right]$$

In the previous embodiment, the weights and PSFs (deconvolution kernels) invert the linear operator only approximately, whereas in this embodiment, the inverse weights and inverse PSFs accurately describe the pseudo-inverse.

It should be appreciated that SVD is only one way to compress the $K$ matrix or $\tilde{K}$ matrix and reduce dimensionality of the image data, other expansions into orthonormal modes are possible such as a principal component analysis (PCA). Any suitable low-rank approximation of the matrix $K/\tilde{K}$ (which means that the full matrix $K/\tilde{K}$ may be approximated using only a few terms) may be used. For example, a low-rank approximation with localized modes may be used (by contrast, SVD will always yield global modes). However, SVD is the preferred method, in that it provides the lowest error with the fewest terms.

The concepts disclosed herein have been described mainly in the context of holography, or holographic microscopy, although phase retrieval methods based on e.g., scatterometry have been described. Another alternative to direct phase measurement techniques (e.g., within the coherent imaging regime) such as holographic microscopy may comprise employing a Gerchberg-Saxton driven phase-retrieval step. The Gerchberg-Saxton phase retrieval algorithm is well known to the skilled person and is described in Gerchberg, R. W.; Saxton, W. O. (1972). "A practical algorithm for the determination of the phase from image and diffraction plane pictures;. Optik. 35: 237-246, which is incorporated herein by reference.

Briefly, Gerchberg-Saxton (GS) phase retrieval algorithm is an iterative phase retrieval algorithm for retrieving the phase of a complex-valued wavefront from two intensity measurements acquired at two different planes. The two planes may comprise the image plane and a pupil plane (Fourier plane) or conjugate thereof, with the wavefront propagation between these two planes determined by Fourier transform. The method uses a nominal or starting phase value (which may be randomly chosen) and iteratively improves on this phase estimate. Such a method begins with a first measured intensity (e.g., from the image plane, although the starting plane is not important) and the starting phase value and determines a new image plane representation or image plane function as a combination of this measured intensity and the starting phase. This function is Fourier transformed and the phase extracted. This phase is combined with the second measured intensity (e.g., from the pupil plane) and the resultant pupil plane function inverse Fourier transformed and the phase extracted. This process is repeated iteratively till convergence on a final phase value.

Such a GS-based phase-retrieval enables a decoupling of (1) phase retrieval and (2) 4D aberration correction, such that they can be executed numerically as two separate consecutive steps in this order. This separation results from the additional diversity obtained for a phase retrieval based on measurements in two observation planes that are beyond the lens, and are separated by a free-space propagator as e.g., between the pupil plane and the image plane. In other phase retrieval methods such as described above, diversity for the phase retrieval is generated via multiple out-of-focus images for different focus positions of the sample, with each measurement made in the image plane beyond the lens. This leads to intermixing of phase-retrieval and 4D aberration correction.

A GS metrology approached is essentially similar to DHM, apart from the fact that the interferometric step in DHM is replaced by a computational GS-based phase-retrieval step, which requires an additional detection in the Fourier plane/pupil plane.

In an embodiment, the aberration correction techniques disclosed herein may be implemented in real-time, where real-time in this context means sufficiently fast for metrology applications in a high volume manufacturing (HVM) manufacturing environment. For high speed implementations, parallel processing architectures can be used since the mode decomposition enables a parallel execution of the modal weighing and modal deconvolution via FFTs

It can be appreciated that the non-iterative aberration correction methods described herein may be subsequently followed by an iterative aberration correction procedure to improve the correction, should it be desirable or required.

While the above examples are described in terms of a metrology tool for measuring overlay and more generally in terms of monitoring lithographic processes in manufacture of integrated circuits, the concepts disclosed herein are not so limited. The metrology tool disclosed herein may be used to measure any characteristic of interest of a structure such as a target, such as focus, dose, critical dimension and EPE (Edge Placement Error), which is a more complex form of overlay (e.g., a combination of overlay and critical dimension uniformity). The metrology tool disclosed herein may be equally used to measure other samples or objects in contexts separate from lithography and IC manufacture.

While the methods disclosed herein are described in relation to correcting of metrology images, and more specifically metrology images obtained in the context of lithography and IC manufacture, the concepts are not so limited. The concepts disclosed herein may be applied to any image subject to non-isoplanatic aberration, as obtained in or for any context or purpose. This includes non-metrology contexts, for example imaging of biological molecules, or metrology contexts separate from lithography and IC manufacture.

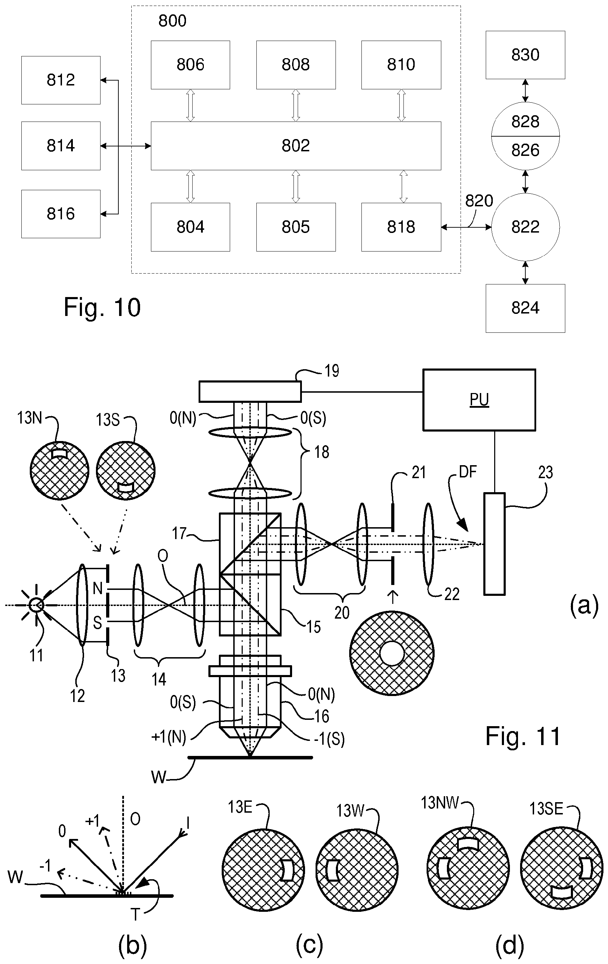

Figure 10 is a block diagram that illustrates a computer system 800 that may assist in implementing the methods and flows disclosed herein. Computer system 800 includes a bus 802 or other communication mechanism for communicating information, and a processor 804 (or multiple processors 804 and 805) coupled with bus 802 for processing information. Computer system 800 also includes a main memory 806, such as a random access memory (RAM) or other dynamic storage device, coupled to bus 802 for storing information and instructions to be executed by processor 804. Main memory 806 also may be used for storing temporary variables or other intermediate information during execution of instructions to be executed by processor 804. Computer system 800 further includes a read only memory (ROM) 808 or other static storage device coupled to bus 802 for storing static information and instructions for processor 804. A storage device 810, such as a magnetic disk or optical disk, is provided and coupled to bus 802 for storing information and instructions.

Computer system 800 may be coupled via bus 802 to a display 812, such as a cathode ray tube (CRT) or flat panel or touch panel display for displaying information to a computer user. An input device 814, including alphanumeric and other keys, is coupled to bus 802 for communicating information and command selections to processor 804. Another type of user input device is cursor control 816, such as a mouse, a trackball, or cursor direction keys for communicating direction information and command selections to processor 804 and for controlling cursor movement on display 812. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 800 in response to processor 804 executing one or more sequences of one or more instructions contained in main memory 806. Such instructions may be read into main memory 806 from another computer-readable medium, such as storage device 810. Execution of the sequences of instructions contained in main memory 806 causes processor 804 to perform the process steps described herein. One or more processors in a multiprocessing arrangement may also be employed to execute the sequences of instructions contained in main memory 806. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 804 for execution. Such a medium may take many forms, including but not limited to, non-volatile media, volatile media, and transmission media. Non-volatile media include, for example, optical or magnetic disks, such as storage device 810. Volatile media include dynamic memory, such as main memory 806. Transmission media include coaxial cables, copper wire and fiber optics, including the wires that comprise bus 802. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 804 for execution. For example, the instructions may initially be borne on a magnetic disk of a remote computer. The remote computer can load the instructions into its dynamic memory and send the instructions over a telephone line using a modem. A modem local to computer system 800 can receive the data on the telephone line and use an infrared transmitter to convert the data to an infrared signal. An infrared detector coupled to bus 802 can receive the data carried in the infrared signal and place the data on bus 802. Bus 802 carries the data to main memory 806, from which processor 804 retrieves and executes the instructions. The instructions received by main memory 806 may optionally be stored on storage device 810 either before or after execution by processor 804.

Computer system 800 also preferably includes a communication interface 818 coupled to bus 802. Communication interface 818 provides a two-way data communication coupling to a network link 820 that is connected to a local network 822. For example, communication interface 818 may be an integrated services digital network (ISDN) card or a modem to provide a data communication connection to a corresponding type of telephone line. As another example, communication interface 818 may be a local area network (LAN) card to provide a data communication connection to a compatible LAN. Wireless links may also be implemented. In any such implementation, communication interface 818 sends and receives electrical, electromagnetic or optical signals that carry digital data streams representing various types of information.

Network link 820 typically provides data communication through one or more networks to other data devices. For example, network link 820 may provide a connection through local network 822 to a host computer 824 or to data equipment operated by an Internet Service Provider (ISP) 826. ISP 826 in turn provides data communication services through the worldwide packet data communication network, now commonly referred to as the "Internet" 828. Local network 822 and Internet 828 both use electrical, electromagnetic or optical signals that carry digital data streams. The signals through the various networks and the signals on network link 820 and through communication interface 818, which carry the digital data to and from computer system 800, are exemplary forms of carrier waves transporting the information.

Computer system 800 may send messages and receive data, including program code, through the network(s), network link 820, and communication interface 818. In the Internet example, a server 830 might transmit a requested code for an application program through Internet 828, ISP 826, local network 822 and communication interface 818. One such downloaded application may provide for one or more of the techniques described herein, for example. The received code may be executed by processor 804 as it is received, and/or stored in storage device 810, or other non-volatile storage for later execution. In this manner, computer system 800 may obtain application code in the form of a carrier wave.

Figure 11(a) presents an embodiment of a metrology apparatus and, more specifically, a dark field scatterometer. A target T and diffracted rays of measurement radiation used to illuminate the target are illustrated in more detail in Figure 11(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC.

A metrology apparatus such as this may be subject to 4D aberrations in its optical system, and the methods disclosed herein may be employed to correct such aberrations. It can be appreciated that, depending on its configuration, the tool may operate in fully incoherent, or fully coherent imaging conditions.

An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 11(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 11(a) and 11(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 11(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 11 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 11) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 11(c) and (d). The use of these, and numerous other variations and applications of the apparatus are described in prior published applications, mentioned above.

Further embodiments are disclosed in the subsequent two lists of numbered clauses:

1. An imaging method comprising:

obtaining a set of primary deconvolution kernels or a set of impulse responses relating to an optical system used to capture said image, where each primary deconvolution kernel of said set of primary deconvolution kernels relates to a respective object point of an object, and each impulse response of said set of impulse responses relates to a respective image point of an image signal;
obtaining said image signal relating to said object, said image signal being subject to one or more imaging effects, said imaging effects including at least one or more non-isoplanatic imaging effects;
performing a low-rank approximation on said set of primary deconvolution kernels or impulse responses to determine respectively a set of deconvolution modes or a set of impulse response modes, each deconvolution mode respectively comprising a modal secondary deconvolution kernel and a modal weight function and each impulse response mode comprising a modal impulse response and a modal inverse weight function; and
obtaining at least approximated imaging effect-free object information related to said object by applying said modal secondary deconvolution kernels and modal weight functions or said modal impulse responses and modal inverse weight functions to said image signal.

2. A method as defined in clause 1, wherein said step of obtaining at least approximated effect-free object information is performed non-iteratively.

3. A method as defined in clause 1 or 2, wherein said obtaining at least approximated effect-free object information step comprises:

weighting said image signal using each said modal weight function or modal inverse weight function to obtain spatially weighted versions of the image signal; and
approximating or obtaining imaging effect-free object information related to said object from a plurality of convolutions of either:

each spatially weighted version of the image signal and its respective modal secondary deconvolution kernel; or
each spatially weighted version of the image signal and its respective modal impulse response.

4. A method as defined in clause 3, wherein said step of obtaining at least approximated imaging effect-free object information comprises summing said convolutions.

5. A method as defined in clause 3 or 4, wherein said step of obtaining at least approximated imaging effect-free object information comprises an initial Fourier transformation step to transform said spatially weighted versions of the image signal, said convolutions being performed in the Fourier domain on the transformed spatially weighted versions of the image signal.

6. A method as defined in clause 3 or 4, wherein said step of obtaining at least approximated imaging effect-free object information comprises a matrix multiplication of the spatially weighted versions of the image signal and the modal secondary deconvolution kernels or modal impulse responses.

7. A method as defined in any of clauses 3 to 6, comprising tuning or selecting the number of deconvolution modes to achieve a desired accuracy.

8. A method as defined in any of clauses 3 to 7, wherein said step of obtaining a set of primary deconvolution kernels or a set of impulse responses comprises determining said a set of primary deconvolution kernels from a set of point spread functions, each point spread function relating to a respective object point of the object.

9. A method as defined in any of clauses 3 to 6, wherein said step of obtaining a set of primary deconvolution kernels or a set of impulse responses comprises determining said set of impulse responses by determining an inverse of a set of point spread functions, each point spread function relating to a respective object point of the object.

10. A method as defined in clause 7 or 8, comprising determining said set of point spread functions from known, measured or simulated imaging effects of said optical system.

11. A method as defined in any preceding clause, wherein said set of primary deconvolution kernels or set of impulse responses comprises a four dimensional set of primary deconvolution kernels or four dimensional set of impulse responses, said dimensions comprising two image dimensions of said image and two object dimensions of said object.

12. A method as defined in any preceding clause, wherein said step of performing a low-rank approximation comprises an initial step of aligning each of said primary deconvolution kernels or impulse responses onto a common point.

13. A method as defined in any preceding clause, wherein said low-rank approximation comprises a singular value decomposition.

14. A method as defined in clause 13, wherein said modal secondary deconvolution kernels or modal impulse responses are determined from highest ranked left-singular vectors of the singular value decomposition.

15. A method as defined in clause 13 or 14, wherein said modal weight functions or modal inverse weight functions are determined from a product of highest ranked singular values and highest ranked transposed right-singular vectors of the singular value decomposition.

16. A method as defined in any preceding clause, wherein the deconvolution modes in said set of deconvolution modes or the impulse response modes in said set of impulse response modes numbers between 1 and 1000.

17. A method as defined in any preceding clause, wherein the deconvolution modes in said set of deconvolution modes or the impulse response modes in said set of impulse response modes number between 5 and 200.

18. A method as defined in any preceding clause, wherein the deconvolution modes in said set of deconvolution modes or the impulse response modes in said set of impulse response modes number between 10 and 100.

19. A method as defined in any preceding clause, wherein said image signal comprises a metrology image signal obtained using a metrology tool.

20. A method as defined in clause 17, wherein said metrology image comprises an image of a structure on a substrate formed using a lithographic process.

21. A method as defined in any preceding clause, wherein said image signal comprises an image wave signal in a coherent imaging regime.

22. A method as defined in any of clauses 1 to 18, wherein said image signal comprises an image power signal in an incoherent imaging regime.

23. A method as defined in any preceding clause, comprising directly using the approximated imaging effect-free object information as an imaging effect corrected image.

24. A method as defined in any preceding clause, comprising digitally propagating the approximated imaging effect-free object information through a coherence model in order to convert from a coherent domain to an incoherent domain.

25. A method as defined in any preceding clause, wherein said step of obtaining a set of primary deconvolution kernels or set of impulse response modes and said step of performing a low-rank approximation are both performed as an initial calibration.

26. A method as defined in any preceding clause, wherein said one or more non-isoplanatic imaging effects comprise at least at least one or more non-isoplanatic aberrations of the optical system.

27. A method as defined in any preceding clause, comprising performing an initial phase retrieval step.

28. A method as defined in clause 27, wherein said performing an initial phase retrieval step comprises performing a Gerchberg-Saxton phase retrieval algorithm.

29. A computer program comprising program instructions operable to perform the method of any of any of clauses 1 to 28, when run on a suitable apparatus.

30. A non-transient computer program carrier comprising the computer program of clause 29.

31. A processing arrangement comprising:

the non-transient computer program carrier of clause 30; and
a processor operable to run the computer program comprised on said non-transient computer program carrier.

32. A metrology device, comprising:

a processing arrangement as defined in clause 31;
said processing arrangement being operable to perform the method of any of any of clauses 1 to 28.

33. A metrology device as defined in clause 32, said metrology device comprising a scatterometer.

34. A metrology device as defined in clause 32, said metrology device comprising a holographic microscope.

i. An imaging method comprising:

obtaining a set of primary deconvolution kernels relating to an optical system used to capture said image, each primary deconvolution kernel of said set of primary deconvolution kernels relating to a respective object point of an object;
performing a low-rank approximation on said set of primary deconvolution kernels to determine a set of deconvolution modes, each mode respectively comprising a modal secondary deconvolution kernel and a modal weight function;
obtaining an image signal relating to said object, said image signal being subject to one or more aberrations of the optical system, said aberrations including at least one or more non-isoplanatic aberrations;
weighting said image signal using each said modal weight function to obtain spatially weighted versions of the image signal;
approximating aberration-free object information related to said object from a plurality of convolutions of each spatially weighted version of the image signal and its respective modal secondary deconvolution kernel.

ii. A method as defined in clause i, wherein said step of approximating aberration-free object information is performed non-iteratively.

iii. A method as defined in clause i or ii, wherein said step of approximating aberration-free object information comprises summing said convolutions.

iv. A method as defined in clause i, ii or iii, wherein said step of approximating aberration-free object information comprises an initial Fourier transformation step to transform said spatially weighted versions of the image signal, said convolutions being performed in the Fourier domain on the transformed spatially weighted versions of the image signal.

v. A method as defined in clause i, ii or iii, wherein said step of approximating aberration-free object information comprises a matrix multiplication of the spatially weighted versions of the image signal and the modal secondary deconvolution kernels.

vi. A method as defined in any preceding clause i to v, wherein said set of primary deconvolution kernels comprises a four dimensional set of primary deconvolution kernels, said dimensions comprising two image dimensions of said image and two object dimensions of said object.

vii. A method as defined in any preceding clause i to vi, wherein said step of performing a low-rank approximation comprises an initial step of aligning each of said primary deconvolution kernels onto a common point.

viii. A method as defined in any preceding clause i to vii, comprising determining said set of primary deconvolution kernels from a set of point spread functions, each point spread functions relating to a respective object point of the object.

ix. A method as defined in clause viii, comprising determining said set of point spread functions from known, measured or simulated aberrations of said optical system.

x. A method as defined in any preceding clause i to ix, wherein said low-rank approximation comprises a singular value decomposition.

xi. A method as defined in any preceding clause i to x, wherein the deconvolution modes in said set of deconvolution modes numbers between 1 and 1000.

xii. A method as defined in any preceding clause i to xi, comprising tuning or selecting the number of deconvolution modes to achieve a desired accuracy.

xiii. A method as defined in any preceding clause i to xii, wherein said image signal comprises a metrology image signal obtained using a metrology tool, and, optionally, said metrology image comprises an image of a structure on a substrate formed using a lithographic process.

xiv. A method as defined in any preceding clause i to xiii, wherein said image signal comprises an image wave signal in a coherent imaging regime or said image signal comprises an image power signal in an incoherent imaging regime.

xv. A metrology device, comprising:

a processing arrangement comprising a processor and a non-transient computer program carrier comprising program instructions operable to perform the method of any of the clauses i to xiv when run on the processing arrangement.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. An imaging method comprising:

    obtaining a set of primary deconvolution kernels or a set of impulse responses relating to an optical system used to capture said image, where each primary deconvolution kernel of said set of primary deconvolution kernels relates to a respective object point of an object, and each impulse response of said set of impulse responses relates to a respective image point of an image signal;
    obtaining said image signal relating to said object, said image signal being subject to one or more imaging effects, said imaging effects including at least one or more non-isoplanatic imaging effects;
    performing a low-rank approximation on said set of primary deconvolution kernels or impulse responses to determine respectively a set of deconvolution modes or a set of impulse response modes, each deconvolution mode respectively comprising a modal secondary deconvolution kernel and a modal weight function and each impulse response mode comprising a modal impulse response and a modal inverse weight function; and
    obtaining at least approximated imaging effect-free object information related to said object by applying said modal secondary deconvolution kernels and modal weight functions or said modal impulse responses and modal inverse weight functions to said image signal.

2. A method as claimed in claim 1, wherein said step of obtaining at least approximated imaging effect-free object information is performed non-iteratively.

3. A method as claimed in claim 1 or 2, wherein said step of obtaining at least approximated imaging effect-free object information comprises:

    weighting said image signal using each said modal weight function or modal inverse weight function to obtain spatially weighted versions of the image signal;
    approximating or obtaining imaging effect-free object information related to said object from a plurality of convolutions of either:

        each spatially weighted version of the image signal and its respective modal secondary deconvolution kernel; or
        each spatially weighted version of the image signal and its respective modal impulse response; and

    summing said convolutions.

4. A method as claimed in claim 1, 2 or 3, wherein said step of obtaining at least approximated imaging effect-free object information comprises an initial Fourier transformation step to transform said spatially weighted versions of the image signal, said convolutions being performed in the Fourier domain on the transformed spatially weighted versions of the image signal.

5. A method as claimed in claim 1, 2 or 3, wherein said step of obtaining at least approximated imaging effect-free object information comprises a matrix multiplication of the spatially weighted versions of the image signal and the modal secondary deconvolution kernels or modal impulse responses.

6. A method as claimed in any preceding claim, wherein said set of primary deconvolution kernels or a set of impulse responses comprises a four dimensional set of primary deconvolution kernels or four dimensional set of impulse responses, said dimensions comprising two image dimensions of said image and two object dimensions of said object.

7. A method as claimed in any preceding claim, wherein said step of performing a low-rank approximation comprises an initial step of aligning each of said primary deconvolution kernels or impulse responses onto a common point.

8. A method as claimed in any preceding claim, comprising:

determining said set of primary deconvolution kernels or set of impulse responses from a set of point spread functions, each point spread functions relating to a respective object point of the object; or

determining said set of impulse responses by determining an inverse of a set of point spread functions, each point spread function relating to a respective object point of the object.

9. A method as claimed in claim 8, comprising determining said set of point spread functions from known, measured or simulated imaging effects of said optical system.

10. A method as claimed in any preceding claim, wherein said low-rank approximation comprises a singular value decomposition.

11. A method as claimed in any preceding claim, wherein the deconvolution modes in said set of deconvolution modes or the impulse response modes in said set of impulse response modes numbers between 1 and 1000.

12. A method as claimed in any preceding claim, comprising tuning or selecting the number of deconvolution modes to achieve a desired accuracy.

13. A method as claimed in any preceding claim, wherein said image signal comprises a metrology image signal obtained using a metrology tool, and, optionally, said metrology image comprises an image of a structure on a substrate formed using a lithographic process.

14. A method as claimed in any preceding claim, wherein said image signal comprises an image wave signal in a coherent imaging regime or said image signal comprises an image power signal in an incoherent imaging regime.

15. A metrology device, comprising:
a processing arrangement comprising a processor and a non-transient computer program carrier comprising program instructions operable to perform the method of any of the claims 1 to 14 when run on the processing arrangement.

Fig. 1

Fig. 2

Fig. 3

Fig. 4

$$\vec{R}\Bigg|\begin{bmatrix}I\end{bmatrix} = \vec{R}\Bigg|\overset{\text{4D-PSF}}{\begin{pmatrix}H\end{pmatrix}} \cdot \begin{bmatrix}O\end{bmatrix}\Bigg|\vec{R}'$$

$$\xrightarrow{\vec{R}'}$$

Fig. 5

Fig. 6

EP 4 296 780 A1

Fig. 7

Fig. 8

Fig. 9

Fig. 10

Fig. 11

(a)

(b)

(c)

(d)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | DENIS LOÏC ET AL: "Fast Approximations of Shift-Variant Blur", ARXIV.ORG, CORNELL UNIVERSITY LIBRARY, 201 OLIN LIBRARY CORNELL UNIVERSITY ITHACA, NY 14853, vol. 115, no. 3, 8 April 2015 (2015-04-08), pages 253-278, XP035934553, DOI: 10.1007/S11263-015-0817-X [retrieved on 2015-04-08] | 1-13,15 | INV. G03F7/20 G06T5/00 |
| Y | * Sections 1, 2, 2.4, 3.5 * ----- | 14 | |
| Y | "METROLOGY METHOD AND DEVICE", RESEARCH DISCLOSURE, KENNETH MASON PUBLICATIONS, HAMPSHIRE, UK, GB , vol. 692, no. 81 1 December 2021 (2021-12-01), XP007149873, ISSN: 0374-4353 Retrieved from the Internet: URL:ftp://ftppddoc/RDData692_EPO.zip Pdf/692081.pdf [retrieved on 2021-11-23] * paragraphs [0061] - [0072] * ----- | 14 | |

**TECHNICAL FIELDS SEARCHED (IPC)**

G03F
G06T

The present search report has been drawn up for all claims

| Place of search | Date of completion of the search | Examiner |
|---|---|---|
| Munich | 13 December 2022 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019197117 A1
- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A

**Non-patent literature cited in the description**

- **L. DENIS ; E. THIEBAUT ; F. SOULEZ ; J.-M. BECKER ; R. MOURYA.** Fast Approximations of Shift Variant Blur. *Int. J. Comput. Vis.,* 2015, vol. 115, 253-278
- **J. SASIAN'S.** *Introduction to Aberrations in Optical Imaging Systems*
- **GERCHBERG, R. W. ; SAXTON, W. O.** A practical algorithm for the determination of the phase from image and diffraction plane pictures. *Optik.,* 1972, vol. 35, 237-246